# FASCICULE DE BREVET EUROPEEN

(11) **EP 3 072 228 B1**
(45) Date de publication et mention de la délivrance du brevet: **20.09.2017**
(21) Numéro de dépôt: 14809492.3
(22) Date de dépôt: 18.11.2014
(51) Int. Cl.: H02M 7/00, H01G 4/40, H05K 7/14

(54) **BLOC DE CAPACITÉS POUR UN MODULE ÉLECTRONIQUE DE PUISSANCE DE VÉHICULE AUTOMOBILE ET PROCÉDÉ DE FABRICATION CORRESPONDANT**
KONDENSATORENPACKUNG FÜR KRAFTFAHRZEUG ELEKTRONISCHES LEISTUNGSMODUL UND ENTSPRECHENDES HERSTELLUNGSVERFAHREN
CAPACITORS PACK FOR MOTOR VEHICLE POWER ELECTRONIC MODUL AND ITS CORRESPONDING MANUFACTURING METHOD

(30) Priorité: 20.11.2013 FR 1361379
(43) Date de publication de la demande: 28.09.2016
(73) Titulaire: Valeo Equipements Electriques Moteur, 94046 Créteil Cedex (FR)
(72) Inventeur: FALGUIER, Manuel, F-94100 Saint-Maur des Fossés (FR); GUERIN, Fabien, F-92320 Chatillon (FR)
(74) Mandataire: Novembre, Christophe Adelphe
(86) Numéro de dépôt international: PCT/FR2014/052954
(87) Numéro de publication internationale: WO 2015/075373

(56) Documents cités:
- CN-U- 202 905 478
- FR-A1- 2 985 597
- US-A- 5 132 896
- US-A1- 2004 036 368

## Description

### DOMAINE TECHNIQUE DE L'INVENTION.

La présente invention se rapporte à un bloc de capacités pour un module électronique de puissance de véhicule automobile et au procédé de fabrication correspondant.

L'invention concerne également des applications dans le domaine des machines électriques tournantes de véhicule automobile.

### ARRIERE PLAN TECHNOLOGIQUE DE L'INVENTION.

Les véhicules automobiles à moteur thermique comportent classiquement un réseau électrique de bord comprenant une batterie, généralement de 12 V, destiné à alimenter en énergie électrique les divers équipements, notamment un démarreur, indispensable pour assurer le démarrage du moteur thermique. Après le démarrage, un alternateur accouplé au moteur thermique assure la charge de la batterie.

De nos jours, le développement de l'électronique de puissance permet de réaliser un bloc convertisseur de puissance alternatif/ continu réversible, c'est-à-dire fonctionnant soit en redresseur, soit en onduleur pour alimenter une seule machine électrique tournante polyphasée réversible qui remplace avantageusement le démarreur et l'alternateur.

Dans un premier temps, cette machine, connue sous le nom d'alterno-démarreur, avait essentiellement pour but de remplir les fonctions autrefois dédiées à l'alternateur et au démarreur, et, accessoirement, de récupérer l'énergie au freinage, ou d'apporter un supplément de puissance et de couple au moteur thermique.

Dans le but d'accroître la puissance et d'améliorer le rendement de l'alterno-démarreur en augmentant sa tension de fonctionnement tout en conservant la possibilité d'utiliser des autres équipements standards, prévus pour une alimentation de 12 V à 14 V, notamment les batteries au plomb, a été développée une architecture de réseau bitension.

Cette architecture consiste donc en un réseau électrique de puissance fonctionnant à une tension supérieure à 14 V, pouvant atteindre 48 V, auquel est relié l'alterno-démarreur et en un réseau électrique de service reliant tous les autres équipements. L'adaptation des niveaux de tensions entre les deux réseaux est assurée par un bloc convertisseur de puissance continu/ continu réversible.

Dans un second temps, des considérations écologiques, ont conduit à concevoir une architecture dite "mild-hybrid" en terminologie anglaise où des alterno-démarreurs ont une puissance, de l'ordre de 8 à 15 KW, suffisante pour entraîner le véhicule à faible vitesse, par exemple en environnement urbain.

De telles puissances posent de nouveaux problèmes au concepteur d'un convertisseur électronique qui comporte classiquement une carte de circuit imprimé sur laquelle sont montés des composants électroniques, notamment des circuits intégrés et des éléments discrets tels que des condensateurs. En effet, l'épaisseur des pistes du circuit imprimé étant faible, il est difficile d'utiliser un tel montage dans le cas d'applications nécessitant de forts courants, par exemple de l'ordre de plusieurs centaines d'ampères.

Dans la demande ce brevet internationale WO2013102720, la société VALEO EQUIPEMENTS ELECTRIQUES MOTEUR propose des modes de réalisation d'un convertisseur courant continu - courant continu bidirectionnel et d'un onduleur réversible adaptés à une architecture "mild-hybrid" grâce à un assemblage original des condensateurs en un bloc de capacités compact au moyen de bus barres.

La demande de brevet US 2004/036368 A1 décrit un redresseur pour un boitier de régulation d'alternateur dont les composants (dont des capacités) sont enrobés dans un matériau thermoconducteur.

Le brevet US 5 132 896 A décrit un bloc de capacités comportant des bus barres de liaison entre les capacités.

Le modèle d'utilité CN 202 905 478 U décrit un bloc de capacités comportant des évents pour un dégazage sur le couvercle du bloc.

Toutefois, les convertisseurs décrits ne sont pas explicitement des onduleurs réversibles aptes à être intégrés sur le palier arrière d'un alterno-démarreur, tels que le sont actuellement les onduleurs de moindre puissance.

Dans ce domaine d'application, l'onduleur doit satisfaire aux contraintes spécifiques d'un fonctionnement sous le capot moteur du véhicule automobile. Il doit, notamment:
- résister à une température élevée;
- résister aux fluides sous le capot;
- résister à une atmosphère corrosive;
- ne pas être sujet à la création de ponts salins entre les broches des condensateurs.

L'entité inventive a été confrontée à ces contraintes pour concevoir un bloc de capacités destiné à être connecté entre un réseau de puissance à 48 V et un onduleur réversible d'un alterno-démarreur de manière à assurer la stabilisation de la tension venant du réseau et la réduction des perturbations générées par les commutations des éléments de puissance.

Le bloc de capacités qui est nécessaire comprend plusieurs condensateurs connectés en parallèle afin de diminuer l'impédance.

Ces condensateurs sont d'un type électrochimique susceptible de produire un dégagement d'hydrogène en cas de surchauffe.

Le dégazage est une contrainte supplémentaire antinomique avec l'exigence d'étanchéité du bloc de capacités pour résister à l'environnement du capot moteur, et qui semble ne pas avoir été prise en compte à ce jour par les solutions connues de l'état de la technique.

### DESCRIPTION GENERALE DE L'INVENTION.

La présente invention vise donc à résoudre cette antinomie.

Elle concerne un bloc de capacités pour un module électronique de puissance de véhicule automobile du type de ceux comprenant une pluralité d'exemplaires d'un condensateur électrochimique agencés dans une cuve métallique au moyen d'un dispositif d'assemblage.

Cette cuve est munie extérieurement d'ailettes de refroidissement et remplie partiellement d'un matériau thermiquement conducteur et électriquement isolant.

Le dispositif d'assemblage comporte un bus barre de polarité positive et un bus barre de polarité négative maintenus l'un sur l'autre sans contact électrique au moyen d'un support isolant et destinés respectivement à être connectés électriquement à une borne positive et à une borne négative de ce module électronique de puissance.

Le bus barre de polarité positive comprend au moins un premier orifice de positionnement recevant une broche positive du condensateur électrochimique et le bus barre de polarité négative comprend au moins un second orifice de positionnement recevant une broche négative du condensateur électrochimique.

Le bus barre de polarité positive comprend également au moins un premier orifice de dégagement permettant à la broche négative de traverser le bus barre de polarité positive sans contact électrique et le bus barre de polarité négative comprend également au moins un second orifice de dégagement permettant à la broche positive de traverser sans contact le bus barre de polarité négative.

Conformément à l'invention, le bloc de capacités pour un module électronique de puissance de véhicule automobile selon l'invention comporte des moyens d'étanchéité et des moyens de dégazage.

Selon une autre caractéristique, ces moyens d'étanchéité sont constitués d'un couvercle fermant la cuve et les moyens de dégazage sont constitués fort avantageusement d'au moins une membrane imper-respirante.

Le couvercle est formé avantageusement du support isolant et d'un capot agencé sur ce support en regard des premier et second orifices de positionnement et des premier et second orifices de dégagement.

Selon une autre caractéristique, la membrane imper-respirante est agencée dans ce capot.

Le support isolant comporte avantageusement un orifice de remplissage de la cuve.

Le condensateur électrochimique présente de préférence une forme générale d'un cylindre et comporte au moins deux exemplaires de la broche négative s'étendant sensiblement extérieurement le long de génératrices de ce cylindre d'un même côté que la broche positive s'étendant axialement.

L'invention concerne également un procédé de fabrication d'un bloc de capacités pour un module électronique de puissance de véhicule automobile présentant les caractéristiques ci-dessus.

Ce procédé est du type de ceux consistant à:
- assembler une pluralité d'exemplaires d'un condensateur électrochimique au moyen d'un dispositif d'assemblage comportant un bus barre de polarité positive et un bus barre de polarité négative maintenus l'un sur l'autre au moyen d'un support isolant et destinés respectivement à être connectés électriquement à une borne positive et à une borne négative du module électronique de puissance; le bus barre de polarité positive comprend au moins un premier orifice de positionnement recevant une broche positive du condensateur électrochimique et le bus barre de polarité négative comprend au moins un second orifice de positionnement recevant une broche négative du condensateur électrochimique; le bus barre de polarité positive comprend également au moins un premier orifice de dégagement permettant à la broche négative de traverser le bus barre de polarité positive sans contact électrique et le bus barre de polarité négative comprend également au moins un second orifice de dégagement permettant à la broche positive de traverser sans contact le bus barre de polarité négative;
- à connecter par soudure la broche positive du condensateur électrochimique au bus barre de polarité positive et la broche négative au bus barre de polarité négative;

Conformément à l'invention, le procédé comporte les étapes suivantes :
- on agence en outre la pluralité d'exemplaires du condensateur électrochimique dans une cuve métallique munie extérieurement d'ailettes de refroidissement en collant de manière étanche une partie périphérique du support sur un bord de la cuve;
- on remplit partiellement la cuve d'un matériau thermiquement conducteur et électriquement isolant par un orifice de remplissage du support;
- on colle de manière étanche un capot muni au moins d'une membrane imper-respirante sur le support en regard des premier et second orifices de positionnement et des premier et second orifices de dégagement.

Cette soudure est réalisée de préférence par laser.

Selon une forme de réalisation particulière, le matériau de remplissage de la cuve est une résine.

L'invention porte aussi sur machine électrique tournante de véhicule automobile du type celles comprenant un module électronique de puissance intégré.

Cette machine électrique tournante est remarquable en ce qu'elle comprend en outre un bloc de capacités tel que celui décrit ci-dessus.

Ces quelques spécifications essentielles auront rendu évidents pour l'homme de métier les avantages apportés par le bloc de capacités selon l'invention, par son procédé de fabrication et par son application.

Les spécifications détaillées de l'invention sont données dans la description qui suit en liaison avec les dessins ci-annexés. Il est à noter que ces dessins n'ont d'autre but que d'illustrer le texte de la description et ne constituent en aucune sorte une limitation de la portée de l'invention.

### BREVE DESCRIPTION DES DESSINS.

La **Figure 1** est une vue générale en perspective d'un bloc de capacités pour un module électronique de puissance de véhicule automobile dans un mode de réalisation préféré de l'invention.
La **Figure 2** est une vue partiellement éclatée du bloc de capacités montré sur la **Figure 1****,** faisant apparaître, supportés par le couvercle, les condensateurs sortis de la cuve.
La **Figure 3** est une coupe du bloc de capacité montré sur la **Figure 1****.**
Les **Figures 4a et 4b** sont des vues en perspective du couvercle montré sur la **Figure 2****,** respectivement sans et avec le capot.
La **Figure 5** est une vue générale en perspective du palier arrière d'une machine électrique tournante de véhicule automobile comprenant un module électronique de puissance associé au bloc de capacités montré sur la **Figure 1****.**

### DESCRIPTION DES MODES DE REALISATION PREFERES DE L'INVENTION.

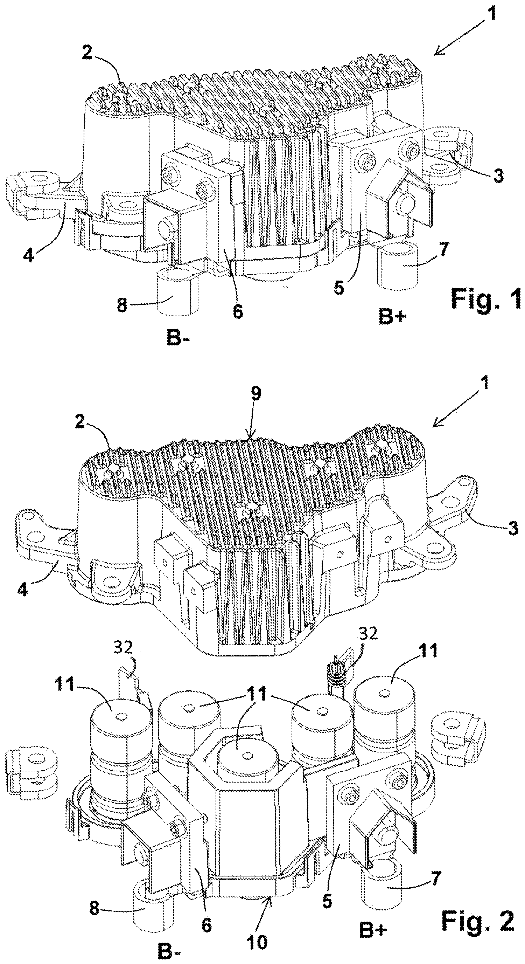

Dans un mode de réalisation préféré de l'invention, comme montré notamment à la **Figure 1**, le bloc de capacités 1 se présente comme un bloc compact, de forme sensiblement prismatique, présentant extérieurement des ailettes de refroidissement 2 et comportant deux pattes de polarité négative 3 et 4, dites pattes négatives, et des bornes 7 et 8 de polarités B+ et B- respectivement. Les deux pattes négatives 3 et 4 sont destinées à être reliées respectivement à deux bornes négatives du module de puissance associé. Les bornes 7, B+, et 8, B-, sont destinées à être reliées au réseau de puissance à 48 V à travers des câbles de connexion respectifs. Les bornes 7 et 8 sont équipées de pièces de détrompage respectives 5 et 8 destinées à empêcher des erreurs dans le raccordement électrique des câbles de connexion.

Ce bloc de capacités 1 est essentiellement constitué de deux parties, comme le montre la vue éclatée de la **Figure 2**:
- un carter ou cuve 9 en aluminium moulé dans la paroi extérieure de laquelle sont formées les ailettes 2 de refroidissement;
- un support isolant 10 formant couvercle et supportant une pluralité d'exemplaires d'un condensateur électrochimique 11, notamment cinq exemplaires.

Un condensateur électrochimique 11 se présente généralement sous la forme d'un corps cylindrique en aluminium muni de deux broches 12, 13, une broche positive 12 et une broche négative 13, soit axiales, s'étendant chacune à chaque extrémité du cylindre, soit situées toutes les deux sur une même extrémité.

Le condensateur électrochimique 11 utilisé dans le mode de réalisation préféré de l'invention est de type "soldering star", d'une capacité nominale comprise entre 2.000 µF et 6.000 µF.

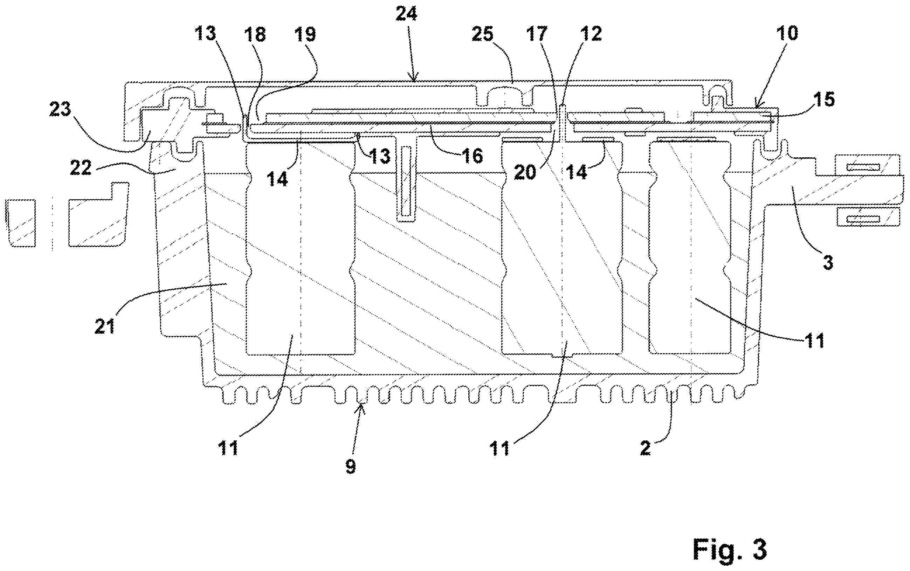

Comme le montre bien la coupe de la **Figure 3**, ce condensateur 11 comporte une broche positive axiale 12 et deux broches négatives 13 (voire trois ou plus formant une étoile - d'où l'appellation) réunies par une couronne annulaire 14.

La partie centrale de cette couronne annulaire 14 est très proche de la broche positive 12 et peut être la cause de la création de ponts salins entre la broche positive 12 et les broches négatives 13 du condensateur 11.

La broche positive 12 de chaque condensateur 11 est soudée au laser sur un bus barre de polarité positive 15 relié électriquement à des pattes positive 32 et à la borne correspondante 7.

Les broches négatives 13 de chaque condensateur 11 sont soudées au laser sur un bus barre de polarité négative 16 relié électriquement aux pattes négatives 3 et 4 et à la borne correspondante 8.

Les deux bus barres 15, 16 sont surmoulés l'un sur l'autre sans contact électrique dans la matière plastique du support 10.

Comme le montre bien la coupe de la **Figure 3**, la broche positive de chaque condensateur 11 est reçue dans un premier orifice de positionnement 17 du bus barre de polarité positive 15, et chacune des broches négatives 13 est reçue dans un second orifice de positionnement 18 du bus barre de polarité négative 16.

Afin de permettre la soudure de chacune des broches négatives 13, le bus barre de polarité positive 15 comprend en regard de chacune de ces broches négatives 13 un premier orifice de dégagement 19 circulaire, de dimension suffisante pour éviter tout contact électrique.

Le bus barre de polarité négative 16 comprend également un second orifice de dégagement 20 autour de chaque broche positive 12 pour permettre à cette broche 12 de traverser le bus barre de polarité négative 16 sans contact électrique.

Comme le montre bien la **Figure 3**, la cuve 9 est partiellement remplie d'un matériau 21, de préférence une résine, électriquement isolant et thermiquement conducteur qui permet un contact thermique entre la pluralité d'exemplaires du condensateur électrochimique 11 et la paroi de la cuve 9.

La fixation du support 10 sur la cuve 9, et l'étanchéité entre un bord 22 de la cuve 9 et une partie périphérique 23 du support 10 en regard, présentant deux surfaces complémentaires imbriquées, sont assurées par un joint de colle.

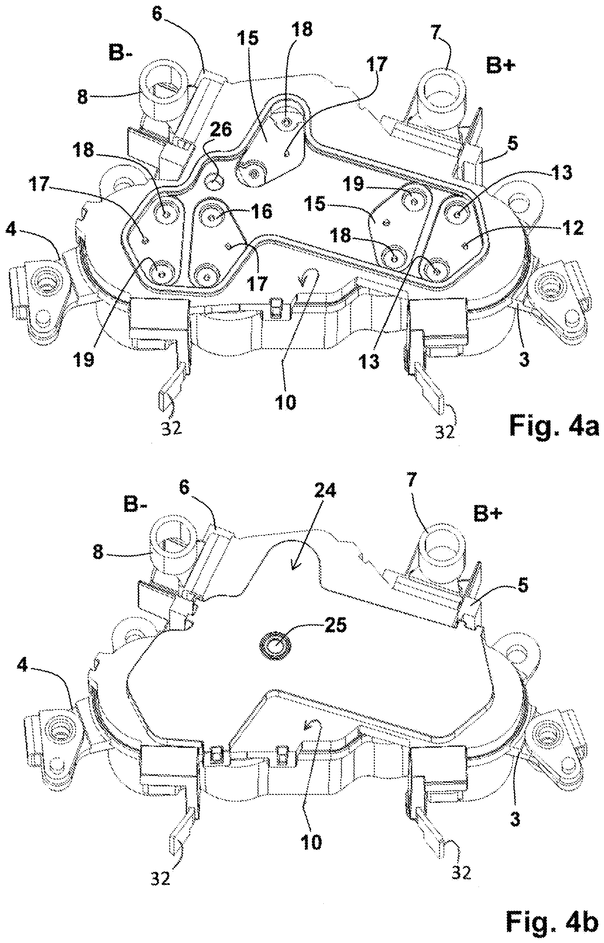

Le procédé de soudure par laser des broches positives et négatives 12, 13 sur les bus barres 15, 16 à travers les premier et second orifices de positionnement 17, 18 ne permettant pas de réaliser l'étanchéité du couvercle 10 à ce niveau, un capot 24 est agencé sur le support 10 en regard des premier et second orifices de positionnement 17, 18 et des premier et second orifices de dégagement 19, 20, comme le montrent bien les **Figures 4a et 4b****.**

Afin de permettre le dégazage en cas de surchauffe, tout en restant étanche, le capot 24 comporte une membrane imper-respirante 25 de type GORE-TEX ®, NANO-TEX ® ou analogue, dont les micro- ou nano-pores laissent passer les gaz mais arrêtent les liquides.

En fonctionnement normal, dans une gamme de température comprise entre - 40 °C et + 140 °C, cette membrane imper-respirante permet également la contraction ou la dilatation de l'air contenu dans la cuve 9.

Dans ce mode de réalisation préféré de l'invention, la cuve 9 est remplie au cours de la fabrication du bloc de capacités 1, avant la mise en place du capot 24, au moyen d'un orifice de remplissage 26 du support 10.

En variante du procédé de soudure par laser, les broches positives et négatives 12, 13 sont brasées sur les bus barres 15, 16.

L'apport d'étain dans les premier et second orifices de positionnement 17, 18 permet de rendre étanche le support 10, et dans ce cas le capot 24 n'est plus nécessaire.

Toutefois pour éviter la corrosion en l'absence de capot 24, les brasures sont protégées par un gel remplissant chaque premier orifice de dégagement 19 du bus barre de polarité positive 15, ainsi que chaque cavité dans la matière du support 10 entourant la broche positive du condensateur 11.

Dans une autre variante, on utilise une soudure électrique. Dans ce cas, la forme demandée au bus barre est telle que la soudure ne réalise plus l'étanchéité de la cuve 9 par le support 10, et qu'il devient impossible de mettre du gel autour des broches 12, 13.

Dans cette autre variante, les soudures et l'intérieur du bloc de capacités 1 sont avantageusement protégés contre les agressions environnementales par des capuchons placés au dessus de chaque premier orifice de dégagement 19 et de chaque cavité du bus barre de polarité positive 15.

Dans l'une et l'autre des variantes ci-dessus, la membrane imper-respirante est agencée dans l'orifice de remplissage du support 10 après remplissage de la cuve 9.

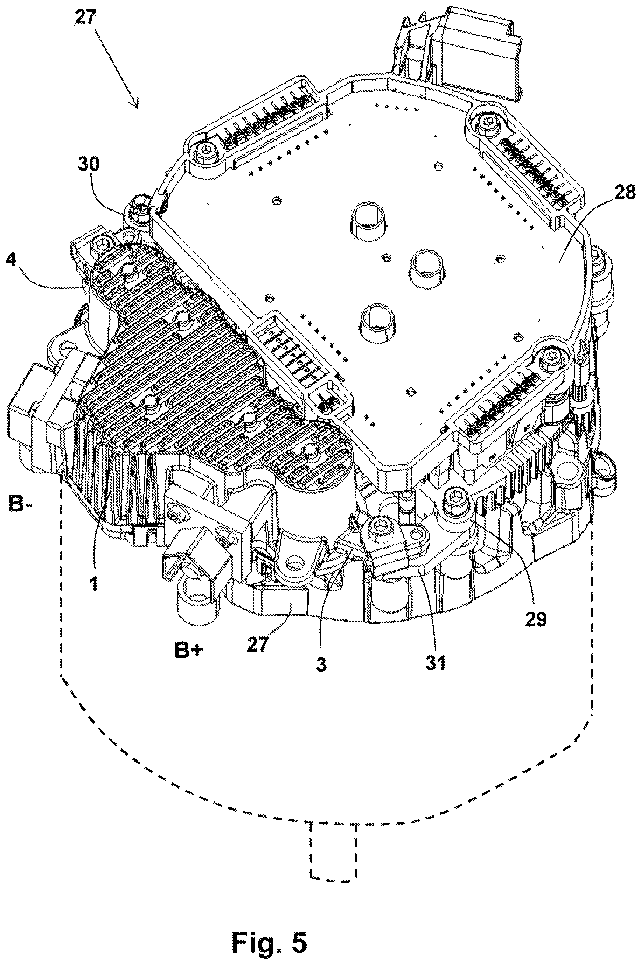

La **Figure 5** montre en détail le palier arrière 27 d'une machine électrique tournante, représentée schématiquement en trait pointillé, tirant bénéfice du bloc de capacités 1 selon l'invention.

Le bloc de capacités 1 est associé à un convertisseur courant - continu / courant alternatif réversible 28 afin de stabiliser la tension B+, B - venant du réseau 48 V et afin de réduire les perturbations générées par les éléments de puissance du convertisseur 28.

Du fait de ses caractéristiques de compacité et de résistance aux contraintes environnementales, le bloc de capacités 1 selon l'invention peut être agencé directement sur le palier arrière 27 de la machine de manière à gagner en encombrement et à réduire la longueur des câbles de connexion, et par conséquent les pertes et les perturbations électromagnétiques, par comparaison à un bloc de capacités qui ne serait pas intégré.

Comme il va de soi l'invention ne se limite pas aux seuls modes d'exécution préférentiels décrits ci-dessus.

Une description analogue pourrait porter sur la fabrication d'un bloc de capacités 1 comportant un nombre d'exemplaires du condensateur électrochimique 11 différent de cinq, ce condensateur 11 comportant un nombre de broches positives et négatives 12, 13 différent de celui spécifié.

Le type de module électronique de puissance 28 n'est donné qu'à titre d'exemple.

Il en est de même des valeurs numériques de la capacité nominale du condensateur 11 et de la tension du réseau de puissance B+, B-.
L'invention embrasse donc toutes les variantes possibles de réalisation dans la mesure où ces variantes restent dans le cadre défini par les revendications ci-après.

## Revendications

1. Bloc de capacités (1) pour un module électronique de puissance (27) de véhicule automobile du type de ceux comprenant une pluralité d'exemplaires d'un condensateur électrochimique (11) agencés dans une cuve métallique (9), munie extérieurement d'ailettes de refroidissement (2) et remplie partiellement d'un matériau (21) thermiquement conducteur et électriquement isolant, au moyen d'un dispositif d'assemblage comportant un bus barre de polarité positive (15) et un bus barre de polarité négative (16) maintenus l'un sur l'autre sans contact électrique au moyen d'un support (10) isolant et destinés respectivement à être connectés électriquement à une borne positive (29) et à une borne négative (30) dudit module électronique de puissance (28), ledit bus barre de polarité positive (15) comprenant au moins un premier orifice de positionnement (17) recevant une broche positive (12) dudit condensateur électrochimique (11) et ledit bus barre de polarité négative (16) comprenant au moins un second orifice de positionnement (18) recevant une broche négative (13) dudit condensateur électrochimique (11), ledit bus barre de polarité positive (15) comprenant également au moins un premier orifice de dégagement (19) permettant à ladite broche négative (13) de traverser ledit bus barre de polarité positive (15) sans contact électrique et ledit bus barre de polarité négative (16) comprenant également au moins un second orifice de dégagement (20) permettant à ladite broche positive (12) de traverser sans contact ledit bus barre de polarité négative (16), caractérisé en que ladite cuve (9) comporte des moyens d'étanchéité (10, 24) et des moyens de dégazage (25).

2. Bloc de capacités (1) pour un module électronique de puissance (28) de véhicule automobile selon la revendication 1, **caractérisé en ce que** lesdits moyens d'étanchéité (10, 24) sont constitués d'un couvercle (10, 24) fermant ladite cuve (9) et lesdits moyens de dégazage (25) sont constitués d'au moins une membrane imper-respirante (25).

3. Bloc de capacités (1) pour un module électronique de puissance (28) de véhicule automobile selon la revendication 2, **caractérisé en ce que** ledit couvercle (10, 24) est formé dudit support (10) et d'un capot (24) agencé sur ledit support (10) en regard desdits premier et second orifices de positionnement (17, 18) et desdits premier et second orifices de dégagement (19, 20).

4. Bloc de capacités (1) pour un module électronique de puissance (28) de véhicule automobile selon la revendication 3, **caractérisé en ce que** ladite membrane imper-respirante (25) est agencée dans ledit capot (24).

5. Bloc de capacités (1) pour un module électronique de puissance (28) de véhicule automobile selon la revendication 4, **caractérisé en ce que** ledit support (10) comporte un orifice de remplissage (26) de ladite cuve (9).

6. Bloc de capacités (1) pour un module électronique de puissance (28) de véhicule automobile selon la revendication 5, **caractérisé en ce que** ledit condensateur électrochimique (11) présente une forme générale d'un cylindre et comporte au moins deux exemplaires de ladite broche négative (13) s'étendant sensiblement extérieurement le long de génératrices dudit cylindre d'un même côté que ladite broche positive (12) s'étendant axialement.

7. Procédé de fabrication d'un bloc de capacités (1) pour un module électronique de puissance (28) de véhicule automobile selon l'une quelconque des revendications 1 à 6 précédentes du type de ceux consistant à:
- assembler une pluralité d'exemplaires d'un condensateur électrochimique (11) au moyen d'un dispositif d'assemblage comportant un bus barre de polarité positive (15) et un bus barre de polarité négative (16) maintenus l'un sur l'autre au moyen d'un support (10) isolant et destinés respectivement à être connectés électriquement à une borne positive (29) et à une borne négative (30) dudit module électronique de puissance (28), ledit bus barre de polarité positive (15) comprenant au moins un premier orifice de positionnement (17) recevant une broche positive (12) dudit condensateur électrochimique (11) et ledit bus barre de polarité négative (16) comprenant au moins un second orifice de positionnement (18) recevant une broche négative (13) dudit condensateur électrochimique (11), ledit bus barre de polarité positive (15) comprenant également au moins un premier orifice de dégagement (19) permettant à ladite broche négative (13) de traverser ledit bus barre de polarité positive (15) sans contact électrique et ledit bus barre de polarité négative (16) comprenant également au moins un second orifice de dégagement (20) permettant à ladite broche positive (12) de traverser sans contact ledit bus barre de polarité négative (16);
- à connecter par soudure ladite broche positive (12) audit bus barre de polarité positive (15) et ladite broche négative (13) audit bus barre de polarité négative (16);
**caractérisé en ce que**:
- on agence en outre la pluralité d'exemplaires dudit condensateur électrochimique (11) dans une cuve (9) métallique munie extérieurement d'ailettes de refroidissement (2) en collant de manière étanche une partie périphérique (23) dudit support (10) sur un bord (22) de ladite cuve (9);
- on remplit partiellement ladite cuve (9) d'un matériau (21) thermiquement conducteur et électriquement isolant par un orifice de remplissage (26) dudit support (10);
- on colle de manière étanche un capot (24) muni au moins d'une membrane imper-respirante (25) sur ledit support (10) en regard desdits premier et second orifices de positionnement (17, 18) et desdits premier et second orifices de dégagement (19, 20).

8. Procédé de fabrication d'un bloc de capacités (1) pour un module électronique de puissance (28) de véhicule automobile selon la revendication 7, **caractérisé en ce que** ladite soudure est réalisée par laser.

9. Procédé de fabrication d'un bloc de capacités (1) pour un module électronique de puissance (28) de véhicule automobile selon la revendication 7, **caractérisé en ce que** ledit matériau (21) est une résine.

10. Machine électrique tournante de véhicule automobile du type celles comprenant un module électronique de puissance (28) intégré, **caractérisée en ce qu'**elle comprend en outre un bloc de capacités (1) selon l'une quelconque des revendications 1 à 6 précédentes.

## Patentansprüche

1. Kondensatorenpackung (1) für ein elektronisches Leistungsmodul (27) eines Automobilfahrzeugs vom Typ jener, welche mehrere Exemplare eines elektrochemischen Kondensators (11) umfassen, die in einem Metallbehälter (9) angeordnet sind, der an der Außenseite mit Kühlrippen (2) versehen und teilweise mit einem thermisch leitenden und elektrisch isolierenden Material (21) gefüllt ist, mittels einer Montagevorrichtung, umfassend einen Busverteiler (15) mit positiver Polarität und einen Busverteiler (16) mit negativer Polarität, die ohne elektrischen Kontakt mittels eines isolierenden Trägers (10) einer über dem anderen gehalten werden, und die dazu bestimmt sind, jeweils mit einem positiven Anschluss (29) und einem negativen Anschluss (30) des elektronischen Leistungsmoduls (28) elektrisch verbunden zu sein, wobei der Busverteiler (15) mit positiver Polarität mindestens eine erste Positionierungsöffnung (17) umfasst, die einen positiven Stift (12) des elektrochemischen Kondensators (11) aufnimmt, und wobei der Busverteiler (16) mit negativer Polarität mindestens eine zweite Positionierungsöffnung (18) umfasst, die einen negativen Stift (13) des elektrochemischen Kondensators (11) aufnimmt, wobei der Busverteiler (15) mit positiver Polarität auch mindestens eine erste Auslassöffnung (19) umfasst, die es dem negativen Stift (13) gestattet, den Busverteiler (15) mit positiver Polarität ohne elektrischen Kontakt zu durchqueren, und wobei der Busverteiler (16) mit negativer Polarität auch mindestens eine zweite Auslassöffnung (20) umfasst, die es dem positiven Stift (12) gestattet, ohne Kontakt den Busverteiler (16) mit negativer Polarität zu durchqueren, **dadurch gekennzeichnet, dass** der Behälter (9) Dichtungsmittel (10, 24) und Entgasungsmittel (25) umfasst.

2. Kondensatorenpackung (1) für ein elektronisches Leistungsmodul (28) eines Automobilfahrzeugs nach Anspruch 1, **dadurch gekennzeichnet, dass** die Dichtungsmittel (10, 24) aus einer Abdeckung (10, 24) bestehen, die den Behälter (9) verschließt, und die Entgasungsmittel (25) aus mindestens einer atmungsfähigen Membran (25) bestehen.

3. Kondensatorenpackung (1) für ein elektronisches Leistungsmodul (28) eines Automobilfahrzeugs nach Anspruch 2, **dadurch gekennzeichnet, dass** die Abdeckung (10, 24) aus dem Träger (10) und einer Haube (24) gebildet ist, die auf dem Träger (10) gegenüber der ersten und zweiten Positionierungsöffnung (17, 18) und der ersten und zweiten Auslassöffnung (19, 20) angeordnet ist.

4. Kondensatorenpackung (1) für ein elektronisches Leistungsmodul (28) eines Automobilfahrzeugs nach Anspruch 3, **dadurch gekennzeichnet, dass** die atmungsfähige Membran (25) in der Haube (24) angeordnet ist.

5. Kondensatorenpackung (1) für ein elektronisches Leistungsmodul (28) eines Automobilfahrzeugs nach Anspruch 4, **dadurch gekennzeichnet, dass** der Träger (10) eine Füllöffnung (26) des Behälters (9) umfasst.

6. Kondensatorenpackung (1) für ein elektronisches Leistungsmodul (28) eines Automobilfahrzeugs nach Anspruch 5, **dadurch gekennzeichnet, dass** der elektrochemische Kondensator (11) eine allgemeine Form eines Zylinders aufweist und mindestens zwei Exemplare des negativen Stifts (13) umfasst, die sich im Wesentlichen außerhalb entlang der Länge der Erzeugenden des Zylinders auf derselben Seite wie der positive Stift (12) erstrecken, der sich axial erstreckt.

7. Verfahren zur Herstellung einer Kondensatorenpackung (1) für ein elektronisches Leistungsmodul (28) eines Automobilfahrzeugs nach einem der Ansprüche 1 bis 6, vom Typ jener, welche bestehen aus:
- Montieren mehrerer Exemplare eines elektrochemischen Kondensators (11) mittels einer Montagevorrichtung, umfassend einen Busverteiler (15) mit positiver Polarität und einen Busverteiler (16) mit negativer Polarität, die mittels eines isolierenden Trägers (10) einer über dem anderen gehalten werden, und die dazu bestimmt sind, jeweils mit einem positiven Anschluss (29) und einem negativen Anschluss (30) des elektronischen Leistungsmoduls (28) elektrisch verbunden zu werden, wobei der Busverteiler (15) mit positiver Polarität mindestens eine erste Positionierungsöffnung (17) umfasst, die einen positiven Stift (12) des elektrochemischen Kondensators (11) aufnimmt, und wobei der Busverteiler (16) mit negativer Polarität mindestens eine zweite Positionierungsöffnung (18) umfasst, die einen negativen Stift (13) des elektrochemischen Kondensators (11) aufnimmt, wobei der Busverteiler (15) mit positiver Polarität auch mindestens eine erste Auslassöffnung (19) umfasst, die es dem negativen Stift (13) gestattet, den Busverteiler (15) mit positiver Polarität ohne elektrischen Kontakt zu durchqueren, und wobei der Busverteiler (16) mit negativer Polarität auch mindestens eine zweite Auslassöffnung (20) umfasst, die es dem positiven Stift (12) gestattet, ohne Kontakt den Busverteiler (16) mit negativer Polarität zu durchqueren;
- Verbinden, durch Schweißen, des positiven Stifts (12) mit dem Busverteiler (15) mit positiver Polarität und des negativen Stifts (13) mit dem Busverteiler (16) mit negativer Polarität;
**dadurch gekennzeichnet, dass**:
- außerdem die mehreren Exemplare des elektrochemischen Kondensators (11) in einem Metallbehälter (9), der an der Außenseite mit Kühlrippen (2) versehen ist, durch dichtes Kleben eines Umfangsabschnitts (23) des Trägers (10) an einen Rand (22) des Behälters (9) angeordnet werden;
- der Behälter (9) teilweise mit einem thermisch leitenden und elektrisch isolierenden Material (21) durch eine Füllöffnung (26) des Trägers (10) gefüllt wird;
- auf dichte Weise eine Haube (24), die mit mindestens einer atmungsfähigen Membran (25) versehen ist, auf dem Träger (10) gegenüber der ersten und zweiten Positionierungsöffnung (17, 18) und der ersten und zweiten Auslassöffnung (19, 20) aufgeklebt wird.

8. Verfahren zur Herstellung einer Kondensatorenpackung (1) für ein elektronisches Leistungsmodul (28) eines Automobilfahrzeugs nach Anspruch 7, **dadurch gekennzeichnet, dass** das Schweißen durch Laser vorgenommen wird.

9. Verfahren zur Herstellung einer Kondensatorenpackung (1) für ein elektronisches Leistungsmodul (28) eines Automobilfahrzeugs nach Anspruch 7, **dadurch gekennzeichnet, dass** das Material (21) ein Harz ist.

10. Sich drehende elektrische Maschine eines Automobilfahrzeugs vom Typ jener, welche ein integriertes elektronisches Leistungsmodul (28) umfassen, **dadurch gekennzeichnet, dass** diese außerdem eine Kondensatorenpackung (1) nach einem der vorhergehenden Ansprüche 1 bis 6 umfasst.

## Claims

1. Capacitor pack (1) for a motor-vehicle power electronics module (27), of the type comprising a plurality of examples of an electrochemical capacitor (11), which examples are arranged, in a metal case (9) that is equipped externally with cooling fins (2) and partially filled with a thermally conductive and electrically insulating material (21), by means of an assembly device including a busbar (15) of positive polarity and a busbar (16) of negative polarity, which busbars are held against each other, without electrical contact, by means of an insulating holder (10) and are intended to be electrically connected to a positive terminal (29) and to a negative terminal (30) of said power electronics module (28), respectively, said busbar (15) of positive polarity comprising at least one first positioning orifice (17) receiving a positive pin (12) of said electrochemical capacitor (11) and said busbar (16) of negative polarity comprising at least one second positioning orifice (18) receiving a negative pin (13) of said electrochemical capacitor (11), said busbar (15) of positive polarity also comprising at least one first clearance orifice (19) enabling said negative pin (13) to pass through said busbar (15) of positive polarity without electrical contact and said busbar (16) of negative polarity also comprising at least one second clearance orifice (20) enabling said positive pin (12) to pass through said busbar (16) of negative polarity without contact, **characterized in that** said case (9) includes sealing means (10, 24) and degassing means (25).

2. Capacitor pack (1) for a motor-vehicle power electronics module (28) according to Claim 1, **characterized in that** said sealing means (10, 24) consist of a cover (10, 24) closing said case (9) and said degassing means (25) consist of at least one waterproof-breathable membrane (25).

3. Capacitor pack (1) for a motor-vehicle power electronics module (28) according to Claim 2, **characterized in that** said cover (10, 24) is formed of said holder (10) and of a cap (24) arranged on said holder (10) facing said first and second positioning orifices (17, 18) and said first and second clearance orifices (19, 20).

4. Capacitor pack (1) for a motor-vehicle power electronics module (28) according to Claim 3, **characterized in that** said waterproof-breathable membrane (25) is arranged in said cap (24).

5. Capacitor pack (1) for a motor-vehicle power electronics module (28) according to Claim 4, **characterized in that** said holder (10) includes an orifice (26) for filling said case (9).

6. Capacitor pack (1) for a motor-vehicle power electronics module (28) according to Claim 5, **characterized in that** said electrochemical capacitor (11) has a general shape of a cylinder and includes at least two examples of said negative pin (13) extending substantially externally along generatrices of said cylinder on the same side as said axially extending positive pin (12).

7. Method for manufacturing a capacitor pack (1) for a motor-vehicle power electronics module (28) according to any one of Claims 1 to 6 above, of the type consisting in:
- assembling a plurality of examples of an electrochemical capacitor (11) by means of an assembly device including a busbar (15) of positive polarity and a busbar (16) of negative polarity, which busbars are held against each other by means of an insulating holder (10) and are intended to be electrically connected to a positive terminal (29) and to a negative terminal (30), of said power electronics module (28), respectively, said busbar (15) of positive polarity comprising at least one first positioning orifice (17) receiving a positive pin (12) of said electrochemical capacitor (11) and said busbar (16) of negative polarity comprising at least one second positioning orifice (18) receiving a negative pin (13) of said electrochemical capacitor (11), said busbar (15) of positive polarity also comprising at least one first clearance orifice (19) enabling said negative pin (13) to pass through said busbar (15) of positive polarity without electrical contact and said busbar (16) of negative polarity also comprising at least one second clearance orifice (20) enabling said positive pin (12) to pass through said busbar (16) of negative polarity without contact;
- using welding to connect said positive pin (12) to said busbar (15) of positive polarity and said negative pin (13) to said busbar (16) of negative polarity;
**characterized in that**:
- the plurality of examples of said electrochemical capacitor (11) are furthermore arranged in a metal case (9) equipped externally with cooling fins (2), by bonding, in a sealtight manner, a peripheral portion (23) of said holder (10) to an edge (22) of said case (9) ;
- said case (9) is partially filled with a thermally conductive and electrically insulating material (21) via a filling orifice (26) of said holder (10);
- a cap (24) equipped with at least one waterproof-breathable membrane (25) is bonded, in a sealtight manner, to said holder (10) facing said first and second positioning orifices (17, 18) and said first and second clearance orifices (19, 20).

8. Method for manufacturing a capacitor pack (1) for a motor-vehicle power electronics module (28) according to Claim 7, **characterized in that** said welding is carried out by laser.

9. Method for manufacturing a capacitor pack (1) for a motor-vehicle power electronics module (28) according to Claim 7, **characterized in that** said material (21) is a resin.

10. Motor-vehicle rotary electric machine, of the type comprising an integrated power-electronics module (28), **characterized in that** it furthermore comprises a capacitor pack (1) according to any one of Claims 1 to 6 above.
